(19) Europäisches Patentamt / European Patent Office / Office européen des brevets

(11) **EP 1 744 187 A1**

(12) **EUROPEAN PATENT APPLICATION**

(43) Date of publication:
**17.01.2007 Bulletin 2007/03**

(51) Int Cl.:
*G02B 5/30* *(2006.01)*    *G02B 27/28* *(2006.01)*

(21) Application number: **05015451.7**

(22) Date of filing: **15.07.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **VRIJE UNIVERSITEIT BRUSSEL 1050 Brussel (BE)**

(72) Inventor: **The designation of the inventor has not yet been filed**

(74) Representative: **Bird, William Edward et al Bird Goen & Co., Klein Dalenstraat 42A 3020 Winksele (BE)**

(54) **Folded radial brewster polariser**

(57)    A compact polarisation selection device (99, 100, 300, 350, 500, 550) for all kind of laser beam applications is proposed. The device (99, 100, 300, 350, 500, 550) comprises at least two components (60, 70), the first component (60) having a surface (80), which is at least partly making an angle of substantially $\theta_{B,i}$ or substantially $-\theta_{B,i}$ with respect to the first direction of the incident beam and the second component having a surface being complementary thereto. $\theta_{B,i}$ thereby is the internal Brewster angle. As the first component (60) and the second component (70) are adapted to be offset from each other such that light leaving the surface (80) of said first component (60) is at least partly coupled into the second component (70) via said complementary shaped surface (74), selection of a polarisation component of the incident light beam is obtained. In case the surfaces are at least partly cylindrical symmetrical, at least partly radial polarised light components are obtained. The polarisation selection device can be used intracavity or extracavity.

Fig. 4a

EP 1 744 187 A1

## Description

### Technical field of the invention

The present invention relates to optical components and methods for controlling the polarisation state of light in an optical system. More particularly, the present invention relates to optical components generating radially polarised light in optical systems.

### Background of the invention

The polarisation state of light influences to a big extent how it interacts with optical elements and materials along its propagation path. For instance, conventional laser systems have been developed which commonly generate a linearly polarised laser beam. According to such conventional approaches, the linear polarisation is generally accomplished by employing a flat planar Brewster window oriented at the Brewster angle (i.e., polarising angle) within the lasing cavity. The planar Brewster window is typically made of a transparent dielectric material such as glass, ZnSe or a dichroic material which has a known index of refraction. Accordingly, light with a polarisation direction parallel to the incidence plane of the Brewster window is totally transmitted while light with a polarisation direction normal thereto is partially reflected therefrom. Nevertheless, it is a disadvantage of the known prior art Brewster polarisers that, for large light beams, a relative large amount of construction material is required.

Recently, developments in the areas of microscopy, digital optical storage, holography, interferometry, spectroscopy, photochemistry, laser based material processing and accelerator and focusing systems for electrons may require laser beams in a special polarisation state known as radial polarisation, i.e. a laser beam whereby the electrical fields are oriented along radial lines. In particular, a radially polarised laser beam can advantageously be focused to a smaller spot to generate a very strong longitudinal electromagnetic field in the focal region thereof. The tighter focus can be used to etch smaller circuits in microchips, improve the resolution of microscopes, and cram more bits onto optical disks. The storage capacity of a DVD, for instance, could be increased by about 150 percent without changing the disk area or the wavelength of light used. Other advantages are that the radial polarisation state is less sensitive to position dependent birefringence introduced by radial thermal gradients and that radial polarised light beams are strongly absorbed, making them very appropriate for material processing applications, such as e.g. cutting applications.

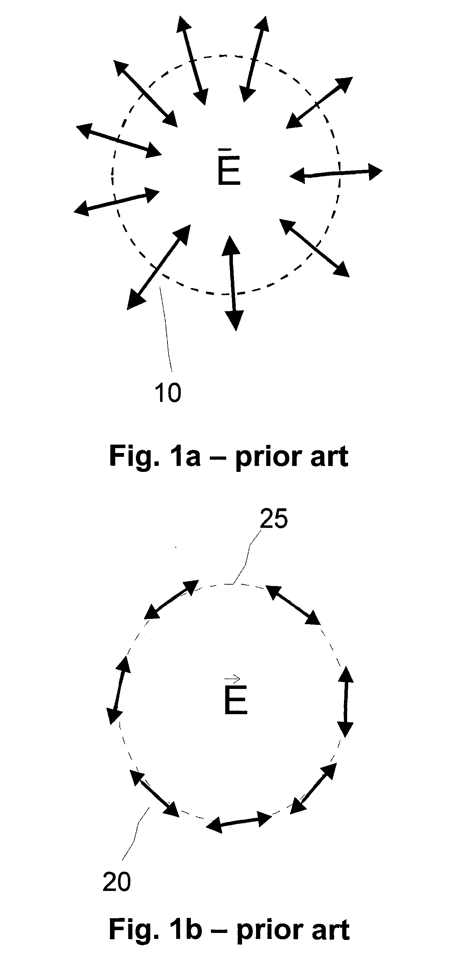

Fig. 1 a and Fig. 1 b schematically indicate in a plane of a beam cross-section the electric field of radially polarised light respectively the electric field of azimuthally polarised light, azimuthally polarised light being the orthogonal counterpart of radially polarised light. For radially polarised light the electric field vectors 10 are oriented in the radial direction and all the radial components oscillate in phase. The radial direction thereby is referred to the centre of the light beam. In the case of azimuthally polarised light, the electric fields 20 are tangential to concentric circles 25 around the centre of the light beam.

Currently, existing laser systems have been able to generate radial polarisation beams to a limited extent, some of them by using quite complex optical schemes outside the resonator, others by using bulky elements inside the resonator. External optical schemes generally involve converting a linearly polarised beam into a radially polarised beam through a series of beam rotations and combinations with external conversion systems. However, such external conversion systems, as discussed by Wilson et al. in Optical Engineering 42(11), pp. 3088-89 (2003) and by Neil et al. in Opt. Lett. 27, pp. 1929-1931 (2002), are rather complicated since the conversion generally requires special optical elements such as a spiral wave plate which is generally very difficult to fabricate in the optical region. In addition, prior approaches generally require a substantially uniform beam profile which in turn results in rather stringent requirements. Other systems use a Mach-Zehnder like interferometer as e.g. described by Tidwell et al. in Appl. Opt. 29, 2234 (1990) and K. S.Youngworth, and T.G.Brown et al in Proc. SPIE 3919 (2000). Such an interferometrical approach was obtained by coherently superposing two linearly polarised beams in order to generate a radially polarised mode of an argon ion laser. A very critical requirement for this method is a sub-wavelength stable alignment. Additionally it is sensitive to non-rotationally symmetric aberrations and requires an input beam with high purity.

Other approaches make use of components integrated in the cavity, such as mode-forming holographic and birefringent elements as for example described by Churin et al. in Opt. Comm. 99, p.13 (1993). Such systems are generally not available in all wavelength regimes. For $CO_2$ lasers, polarisation selective diffractive mirrors were used by Nesterov et al. in J. Phys. D. Appl. Phys. 32, pp. 2871-75 (1999). Two approaches for Nd:YAG lasers are known. With the aid of a discontinuous phase element to select the TEM01 mode and a birefringent beam displacer, the selection and coherent summation of two TEM01-modes inside the resonator was achieved by Oron et al. in Appl. Phys. Lett. 77 (21), 3322-3324 (2000). Another technique, by Moshe et al., is based on the different focusing between radially and tangentially polarised light (bi-focusing) in thermally stressed isotropic laser rods, as described in Opt. Lett. 28 (10), 807-809 (2003).

Another prior-art method by Moser et al., as described in Laser Physics Letters 1 (5), pp. 234-236 (2004) is based on a dielectric mirror exhibiting polarisation-dependent reflectivities due to a resonant circular grating on top of the multi-layer reflector The generation of radial polarisation was achieved by means of a polarisation-selective end mirror in the laser resonator. The purpose of the mirror is to get high reflectivity for the radial polarisation (TM, E-field oscillating perpendicular to the grating lines) and inflict significant losses to the tangential polarisation (TE, E-field oscillating parallel to the grating lines).

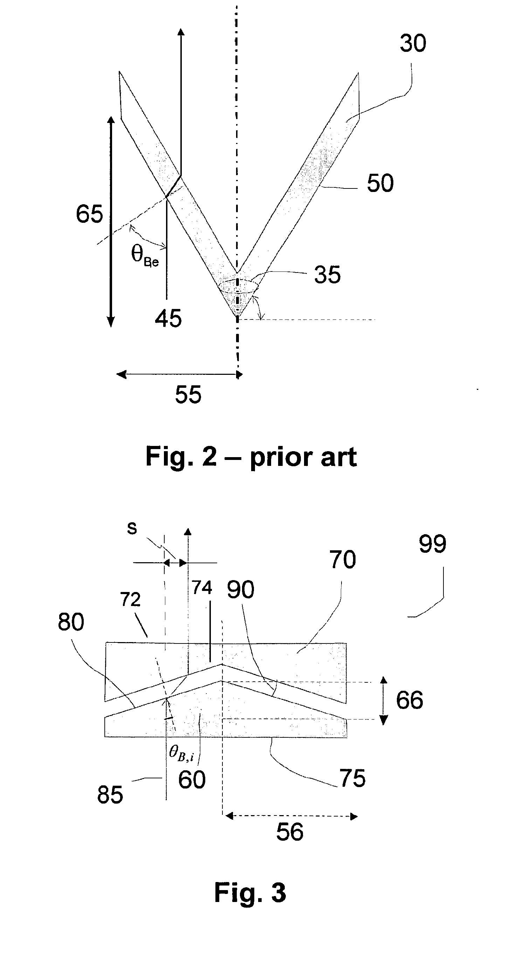

Another known example of a single element device for selecting radially polarised light of a light beam is shown in Fig. 2. The device 30 is a hollow cone-like structure. A device 30 is shown in cross-section, comprising a component of optical material exposed in air, having a corresponding component cross-section 35. The slope 50 of the hollow cone-like structure is determined by Brewster angle $\theta_{B,e}$ corresponding to the refractive index $n_m$ of the cone material at the wavelength of the incident light ray 45. It is well known in the art that the external Brewster angle $\theta_{B,e}$ is defined by the equation $\tan(\theta_{B,e}) = n_m$. The volume of the device is determined by the radius 55 of the base of the cone, and the height 65 of the cone. As such optical devices preferably need to be made of a single piece of optical material, in order to reduce possible artefacts, the costs, both in material and in effort, significantly increases with increasing diameter in order to have devices allowing to select radially polarised light in larger light beams.

Although several polarisation selection devices exist, none of the above systems provides a cheap and efficient way to produce radially polarised laser beams.

## Summary of the invention

It is an object of the present invention to solve at least part of the problems present in the prior art devices. It is a further object of the present invention to provide optical components and methods for controlling the polarisation state of light in an optical system. More particularly, the object of the present invention can relate to optical components and methods generating polarised light in optical systems, whereby the amount of material required for the optical components is reduced compared to prior art devices.

It can be an advantage of embodiments of the present invention that optical components and methods are provided for generating polarised light in optical systems, e.g. methods and devices to select a radial or azimuthal polarisation state of a light beam. An advantage of the present invention can be that such devices have reduced dimensions and enhanced functionality, e.g. that the undesired polarisation component can be evacuated from the device.

The above objectives are accomplished by a method and device according to the present invention.

The present invention relates to a device for selecting a polarisation state of light of a light beam, the device comprising at least a first component and a second component, said first component comprising a first surface and a second surface, said first surface being adapted for receiving an incident light beam and guiding said light beam in a first direction to a second surface, at least part of said second surface being inclined under a first polarisation selective angle with respect to said first direction, i.e. including a first polarisation selective angle with the first direction, and said second component comprising a first surface being adapted for coupling out from said second component an incident light beam and a second surface having a shape being substantially a complementary shape of said second surface of said first component, said first component and said second component being adapted to be offset from each other such that light leaving said second surface of said first component is at least partly coupled into said second component via said second surface of said second component.

The first polarisation selective angle may be substantially the internal Brewster angle $\theta_{B,i}$ and/or substantially minus the internal Brewster angle $-\theta_{B,i}$, $\theta_{B,i}$ being the complement of the external Brewster angle $\theta_{B,e}$, said external Brewster angle being determined by $\tan(\theta_{B,e}) = n_m$.

Said first surface of said first component and said first surface of said second component may be substantially flat. Said at least part of said second surface of said first component may comprise at least one first facet being inclined under said first polarisation selective angle, i.e. a plane of said at least part of said second surface including the first polarisation selective angle with said first direction.

Said at least part of said second surface of said first component may comprise at least one second facet being inclined under a second polarisation selective angle, i.e. said second facet including a second polarisation selective angle with said first direction, said second polarisation selective angle being substantially different from said first polarisation selective angle.

The second polarisation selective angle may be substantially the opposite angle of the first polarisation selective angle.

The at least part of said second surface of said first component may comprise at least a plurality of first facets being inclined under said first polarisation selective angle with respect to a direction of an incident light beam, i.e. a plurality of first facets includes a first polarisation selective angle with the incident light beam.

At least part of said second surface of said first component may comprise at least a plurality of second facets being inclined under said second polarisation selective angle with respect to a direction of an incident light beam, i.e. a plurality of second facets includes a second polarisation selective angle with the incident light beam.

Said at least part of said second surface of said first component may comprise at least a plurality of second facets being substantially parallel with said direction of said incident light beam.

The period of said facets may be 15 times larger than the wavelength of the light beam, more preferably 20 times larger than the wavelength of said light beam, even more preferably 40 times larger than the wavelength of said light beam.

Said plurality of first facets may alternate with said plurality of second facets.

The first component and said second component may be offset such that light coupled out through said first facets of said first component substantially is coupled into said first facets of said second component and light coupled out through said second facets of said first component substantially is coupled into said second facets of said second component.

The device may be adapted for receiving a light beam substantially orthogonally incident on said first surface of the first component and for substantially selectively transmitting a first polarisation state of said light in the same direction.

The first polarisation state may be the radial polarisation state.

The shape of said second surface of said first component and said second surface of said second component may be concentric.

Facets present at said second surfaces may be cylindrical symmetrical.

Facets at said second surface may all extend in a same direction.

Said second surface may be shaped such that a cross-section perpendicular to said same direction is substantially tooth-shaped. Substantially tooth-shaped may be symmetrical tooth-shaped, asymmetrical tooth-shaped or saw tooth-shaped.

One of said second surfaces may have an indenting conical shape and said other second surface may have a protruding conical shape.

The device may furthermore comprise a means for mechanically offsetting said components, adapted for creating a gap between said components.

The gap between said components may be such that the contrast between a first polarisation component and its orthogonal polarisation component is maximal. The gap may be filled with a gas or gas mixture.

The first polarisation component may be the radial polarisation component, and its orthogonal polarisation may be the azimuthal polarisation component. Alternatively, the first polarisation component may be a TM polarisation component and the orthogonal polarisation component may be a TE polarisation component, with respect to a plane perpendicular to the average direction of the light beam.

Said device furthermore may comprise at least one intermediate component, said intermediate component having a first surface and a second surface opposite said first surface, at least part of each of said first surface and said second surface being inclined under a polarisation selective angle with respect to a direction of an incident light beam, i.e. at least part of each of said first surface and second surface including a polarisation selective angle with a direction of an incident light beam, said intermediate component being adapted for being positioned with said first surface and said second surface between said first component and said second component.

The first surface of said first component and/or said first surface of said second component may comprise an anti-reflective coating.

Said first surface of said first component and/or said first surface of said second component may comprise a polarisation contrast improving coating.

The device may comprise recombination zones between said second surfaces, wherein at least one of the second surfaces comprises a reflecting or absorbing means located in a substantial part of the recombination zones.

Said at least a first component and a second component may be made of the same material.

The device may allow substantially full evacuation of light reflected at the second surface of said first component.

The device may allow substantially full evacuation of the light reflected at the second surface of said first component and the evacuated light is substantially not coinciding with the direction of the incident light beam.

The facets of the second surface(s) may be provided such that $\left(2.k+1\right)\dfrac{P}{2} \geq \dfrac{\phi}{8}$ is fulfilled, k being an integer value, P being the period between different facets of a second surface and $\phi$ being the illumination beam diameter.

Substantially the first polarisation selective angle may include $\theta_{B,i} + \alpha_1$ or $\theta_{B,i} - \alpha_2$, $\alpha_1$ preferably being smaller than 6° for low refractive index materials, such as e.g. glass type materials, smaller than 3,5° for medium refractive index materials such as e.g. ZnSe, and smaller than 0,25° for high refractive index materials, such as e.g. Ge, and $\alpha_2$ being smaller than 3° for low refractive index materials such as e.g. glass type materials, smaller than 1° for medium refractive index material such as e.g. ZnSe and smaller than 0,25° for high refractive index materials such as e.g. Ge, and the angles $\alpha_1$ and $\alpha_2$ preferably being larger than the divergence of a laser beam, preferably at least 3 times or 5 times or 10 times. The divergence of a laser beam typically may be about 1 miliradian or 3 arc minutes, i.e. 0,05°.

The invention also may relate to an optical system comprising a light source adapted for generating a light beam and a device adapted for selecting a radial or azimuthal polarisation state of said light beam as described above.

The invention furthermore relates to a laser comprising a laser cavity adapted for supporting lasing action and a device adapted for selecting a polarisation state of said light beam as described above wherein said device is positioned such that light reflected at said first surface of said first component is substantially not coinciding with the optical path of the laser cavity. The device adapted for selecting a polarisation state may be placed such that said first surface of said first component substantially makes an angle being larger than the divergence of a laser beam, preferably at least 3 times or 5 times or 10 times with the direction perpendicular to the optical path of the laser cavity. The divergence of a laser beam typically may be about 1 miliradian or 3 arc minutes, i.e. 0,05°.

The invention also relates to a laser comprising a laser cavity adapted for supporting lasing action and a device adapted for selecting a polarisation state of said light beam as described above, wherein said device is positioned such that said first surface of said first component is perpendicular to the optical path of the laser cavity and is adapted such that light reflected at said second surface of said first component is coupled out of said first component substantially not coincident with the optical path of the laser cavity.

The invention furthermore relates to a method for creating a substantially radially polarised light beam, the method comprising providing a light beam perpendicularly to a first optical component, refracting said light beam at a surface of said first optical component including an angle with said light beam, being substantially an internal Brewster angle for said first optical component (60), resulting in a first sub-beam coupled out of said first optical component, providing said first sub-beam under an angle being substantially an external Brewster angle of a second optical component, resulting in a second sub-beam coupled in into said second optical component, coupling out said second sub-beam from said second optical component. After refracting said light beam and prior to providing said first sub-beam, the method may comprise guiding said first sub-beam through a gap between the first optical component and the second optical component.

Said light beam may have a symmetry axis and providing a light beam to said first optical component may comprise providing said light beam such that the symmetry axis of the light beam passes through the centre of symmetry of the active area of said first and said second optical component.

The method furthermore may comprise, after said providing a light beam perpendicular to a first optical component, reflecting at least partially the orthogonal unwanted polarisation state such that at least part thereof is directed substantially orthogonally to the first surface of said first optical component and that at least part thereof is substantially coupled out. Reflecting at least partially the orthogonal unwanted polarisation state may comprise reflecting at least partially the orthogonal unwanted polarisation state over an internal Brewster angle of said first optical component, resulting in a third sub-beam redirected towards a first surface of said first optical component and totally reflecting said third sub-beam over an angle of substantially the double of the internal Brewster angle and redirecting this beam to the second surface of the first optical component where said third sub-beam is split again in a fourth reflected and a fifth refracted sub-beam, whereby the fourth sub-beam is directed substantially orthogonally to the first surface of said first optical component and substantially coupled out.

The method further may comprise absorbing or reflecting that part of the light beam that is incident on the recombination parts of the second surfaces of the first and second optical components. Absorbing or reflecting may comprise partially reflecting the orthogonal unwanted polarisation state over an internal Brewster angle of the first optical component, resulting in a third sub-beam directed again to the first surface of the first optical component.

It is to be noted that the term "internal Brewster angle" refers to the conventional Brewster angle for light that propagates from a high refractive index material to a low refractive index material.

In a further aspect, the present invention also relates to a device for selecting a polarisation state of light of a light beam, the device comprising at least a first component, said first component comprising a first surface and a second surface, said first surface being adapted for receiving an incident light beam, said first component being for guiding said received light beam in a first direction to a second surface, at least part of said second surface including a first polarisation selective angle with said first direction. Said first surface may be substantially flat, i.e. may be substantially lying in a single plane. Said at least part of said second surface may be said full second surface. Said device comprising at least a first component may be said device consisting of a single component, i.e. consisting of said first component.

Said at least part of said second surface may be concentric. Said at least part of said second surface may be conical.

Said at least part of said second surface may comprise a plurality of facets including said first polarisation selective angle with said first direction. Said plurality of facets may be elongate in at least one direction perpendicular to said first direction. Said plurality of facets may be concentric.

The device may comprise means adapted for redirecting a light beam coupled out by said first component into a light beam propagating substantially along said first direction.

The device may comprise means adapted for redirecting a light beam coupled out by said first component towards said first component such that said light beam is coupled in said first component under a second polarisation selective angle, e.g.under the external Brewster angle for said first component.

According to said second aspect, the invention also relates to a method for creating a polarised light beam, the method comprising providing a first light beam perpendicularly to a first optical component and refracting said light beam over a first polarisation selective angle, being e.g. substantially an internal Brewster angle for said first optical component, resulting in a second light beam coupled out of said first optical component.

The method may comprise redirecting said second light beam such that it propagates in a same direction as said first light beam.

The method may comprise redirecting said second light beam such that it incides a second time on said first optical component and such that it is refracted over a second polarisation selective angle, being e.g. substantially the external Brewster angle for said first optical component.

Specific features and advantages of embodiments of the first aspect may be applied mutatis mutandis to the embodiments of the second aspect of the present invention.

It is a further advantage of embodiments of the present invention that a set of industrial-proof optical components is provided.

It is an advantage of the present invention that widely used materials can be applied for the implementation and that the invention can be used in very high optical power applications.

It is an advantage of embodiments of the present invention that the physical principle used is not based on "sub-wavelength" elements but on macroscopic elements resulting in a more cost effective manufacturing, both from economic and timing viewpoint. It is an advantage of embodiments of the present invention that the folded radial Brewster polariser can be inserted into a laser cavity.

It is an advantage of the present invention that the embodiments can be used on existing optical systems.

It furthermore is an advantage that no complex optical systems need to be used outside the optical system.

It is also an advantage of embodiments of the present invention that the laser beams are orthogonally incident and emergent on the polariser such that alignment of the device is straightforward.

Another significant advantage is the fact that embodiments of the present invention provide folded polarisers that occupy substantially less space along the propagation direction of the laser beam, use less optical material than prior art devices and hence are cheaper.

It is furthermore an advantage of embodiments of the present invention that the devices can be implemented in all regions of the electromagnetic spectrum. One single device, fabricated in a given material, furthermore allows to cover a substantially broad range of the electromagnetic spectrum, i.e. the range wherein the used material is substantially transparent and/or wherein the used material features substantially low dispersion.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The teachings of the present invention permit the design of improved methods and apparatus for modifying the polarisation state of a light beam to a radially polarised light beam.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

**Brief description of the drawings**

Fig. 1 a and Fig. 1 b show a cross-section of a light beam being radially respectively azimuthally polarised.

Fig. 2 shows a side view of a basic configuration of a Brewster polariser, as known from the prior art.

Fig. 3 shows a side view of a basic configuration of a radial Brewster polariser according to a first embodiment of the present invention.

Fig. 4a and Fig. 4b show a side view respectively top view of a folded configuration of a folded radial Brewster polariser according to a second embodiment of the present invention.

Fig. 4c shows a side view of a folded configuration of a folded radial Brewster polariser as shown in Fig. 4a for non-orthogonal incident light.

Fig. 5 shows a more detailed example of a folded configuration of a folded radial Brewster polariser according to a second embodiment of the present invention.

Fig. 6 is a graph indicating the reflectivity as a function of the mechanical displacement between two complementary parts of a triangular configuration of a folded radial Brewster polariser according to a second embodiment of the present invention.

Fig. 7a shows a saw-tooth configuration of a folded radial Brewster polariser comprising recombination zones according to a third embodiment of the present invention.

Fig. 7b shows a saw-tooth configuration of a folded radial Brewster polariser comprising additional reflection means near the recombination zones, according to a fourth embodiment of the present invention.

Fig. 8 shows a folded configuration of a multi-element folded radial Brewster polariser according to a sixth embodiment of the present invention.

Fig. 9 shows a laser cavity of an optical laser system comprising a folded radial Brewster polariser, according to seventh embodiment of the present invention.

Fig. 10a and Fig. 10b show asymmetric triangular examples of a folded radial Brewster polariser, according to the eight embodiment of the present invention.

Fig. 11 shows an elongated folded linear Brewster polarisation selective device, according to a tenth embodiment of the present invention.

Fig. 12 shows a single component polarisation selective device according to embodiments of a second aspect of the present invention.

Fig. 13 shows a single component polarisation selective device with a reflecting means for guiding the light back into the single component polarisation selective device according to a further embodiment of the second aspect of the present invention.

In the different figures, the same reference signs refer to the same or analogous elements.

## Description of illustrative embodiments

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

Moreover, the terms top, bottom and the like in the description are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. Thus, the scope of the expression "a device comprising means A and B" should not be limited to devices consisting only of components A and B. It means that with respect to the present invention, the only relevant components of the device are A and B.

The invention will now be described by a detailed description of several embodiments of the invention. It is clear that other embodiments of the invention can be configured according to the knowledge of persons skilled in the art without departing from the true spirit or technical teaching of the invention, the invention being limited only by the terms of the appended claims.

In the described embodiments of the present invention, a device and method for selection of the polarisation state of a light beam are provided. The polarisation state that can be selected is a radial polarisation state, i.e. as shown in Fig. 1a, or an azimuthal polarisation state, i.e. as shown in Fig. 1b. Although in the specific embodiments shown the focus will be on selection of the radial polarisation state, i.e. the transmitted light, for use, use could also be made of the reflected light, resulting in selection of the azimuthal polarisation state.

In a first embodiment, the invention relates to a polarisation selection device and a method for selecting a polarisation state of light of a light beam. The selectable polarisation state is any of a radial polarisation state or an azimuthal polarisation state. The polarisation selection device 99, an example of which is shown in cross-section in Fig. 3, comprises at least two components, being at least a first component 60 and a second component 70 which have surfaces with a specific, mating shape. The first component 60 comprises a first surface 75 being substantially flat, shown as the horizontal bottom surface in Fig. 3, and being adapted for receiving an incident light beam 85 and guiding the light beam 85 in a first direction towards a second surface 80 of the first component 60. At least part of the second surface 80 includes a polarisation selective angle with the first direction of the light beam 85 incident on the second surface 80. The polarisation selective angle may be, but is not limited to, substantially the internal Brewster angle $\theta_{B,i}$ or substantially minus the internal Brewster angle $-\theta_{B,i}$. It is to be noted that the term "internal Brewster angle" refers to the complement of the conventional Brewster angle. With "at least part" is meant at least 50% of the second surface 80, preferably at least 66% of the second surface 80, even more preferably at least 75% of the second surface 80, or there may be meant substantially the full second surface 80 being under substantially a polarisation selective angle and/or substantially minus that polarisation selective angle. With "substantially the internal Brewster angle $\theta_{B,i}$ or substantially minus the internal Brewster angle $-\theta_{B,i}$", is meant making an angle equal to the internal Brewster angle or an angle $\theta_{B,i}$ + $\alpha$, with $\alpha$ being in the interval [-6°;+3.0°] for low refractive index materials (e.g. glass type materials), in the interval [-3.5°;+1.0°] for medium refractive index materials such as ZnSe and in the interval [-0.25°;+0.25°] for high refractive index materials such as Ge, or an angle equal to minus the internal Brewster angle or an angle $-\theta_{B,i}-\alpha$, with $\alpha$ being in the interval [-6°;+3.0°] for low refractive index materials (e.g. glass type materials), in the interval [-3.5°;+1.0°] for medium refractive index materials such as ZnSe and in the interval [-0.25°;+0.25°] for high refractive index materials such as Ge. The surfaces are at least partly concentric, i.e. the surfaces are at least partly cylindrical symmetrical. In the example of Fig. 3, the complete second surface 80 includes an angle of substantially the internal Brewster angle $\theta_{B,i}$ with the first direction, resulting in a cone shape of the second surface 80 of the first component 60. The internal Brewster angle $\theta_{B,i}$ is the complement of the external Brewster angle $\theta_{B,e}$, which is well known by the person skilled in the art and which is e.g. determined by $\tan(\theta_{B,e})= n_m$, in case the medium surrounding the component has a refractive index 1. The second component 70 also comprises a first surface 72 and a second surface 74, the first surface 72 being substantially flat and indicated as the substantially horizontal top surface in Fig. 3, and the second surface 74 having substantially the complementary shape of the second surface 80 of the first component 60. Both second surfaces, i.e. the second surface 80 of the first component 60 and the second surface 74 of the second component 70, thus are complementary shaped surfaces. With "complementary shaped" is meant that, when the second surface 80 of the first component 60 and the second surface 74 of the second component 70 would be brought in contact with each other, substantially the full surfaces would be in contact. In other words, the first component 60 and the second component 70 are adapted to be offset from each other such that, in a given direction, the distance between the second surface 80 of the first component 60 and the second surface 74 of the second component 70 is equal, i.e. the surfaces 80, 74 are equidistant. In this way, the first component 60 and the second component 70 can be offset such that light leaving the second surface 80 of the first component 60 is at least partly coupled in into the second component 70 at its second surface 74. The first surface 72 and the second surface 74 of the second component 70 are also at least partly concentric, i.e. cylindrical symmetrical. Preferably, these surfaces are fully concentric, i.e. fully cylindrical symmetrical. The second surfaces 80, 74 thus are at least partly ring shaped and cylindrical symmetrical. A gap 90 is provided between said first and second components 60, 70, which may be an air gap, but also may be a gap filled with a gas or gas mixture, etc. By using refraction at a component 60, 70 / gap 90 interface under the internal Brewster angle at a cylindrical symmetric surface, the radial component of a light beam 85 can be selected to be transmitted completely, whereas the azimuthal component of the light beam 85 is at least partly reflected. The complementary surfaces of the components thus are brought into close proximity but separated from each other by an appropriate mechanical offset mechanism. In other words, the at least first and second components 60, 70 may be attached to each other by means of a mechanical offset means such that the interdistance or the width of the gap 90 is fixed. Such mechanical offset means can be a ring with height corresponding to the dimensions of the air gap, which is located outside the active zone of the optical element, or any other means allowing to obtain a fixed distance between adjacent components. The use of two components 60, 70 allows that the light beam 85, after transmission at the second surface 74 of the second component 70, has the same direction as the direction of the light beam 85 incident on the second surface 80 of the first component 60.

The operation principle of the device 99 is based on the Brewster effect: the electric field component of light incident at an interface under the Brewster angle and parallel to the plane of incidence is transmitted for 100%. The electrical field component which is orthogonal to the plane of incidence is only partially transmitted, depending on the refractive indices of the materials forming the interface. If light is incident at a cylindrical symmetrical surface under Brewster angle, the electrical field components which are radially oriented are transmitted for 100%, whereas the azimuthal or tangential field components are only partially transmitted and partially reflected. It is to be noted that reflected light is purely azimuthally oriented. A few values of the reflection coefficient at the first component 60 / gap 90 interface for various optical materials are indicated in Table 1 in the column indicated by $R_\perp$. The contrast at the transmitted side between the radial polarised light and the azimuthal polarised light based on a single reflection is given by $1 / R_\perp$. As at the gap 90 / component 70 interface the same reflection and transmission values for the radial and azimuthal component are valid, the radial/azimuth ratio at the transmitted side of the polarisation selection device is $\dfrac{1}{R_\perp^2}$ .

The device of Fig. 3, shown by way of example, is adapted for receiving the incident light beam substantially orthogonally or orthogonally incident on the first surface 75. The light is then refracted at the second surface 80, having a conical shape. As the angle of incidence of the light on the second surface 80 of the first component 60 then is equal to the first polarisation selective angle, for example angle $\theta_{B,i}$ being the internal Brewster angle, the radially polarised component of the light beam 85 is completely transmitted, whereas the azimuthal component of the light beam is at least partly reflected. It may be advantageous that the device 99 is optimised for receiving a substantially orthogonally or an orthogonally incident light beam on the first surface 75 of the first component 60, as the latter may allow a more easy and user-friendly positioning of the component in an optical system. It nevertheless is obvious for a person skilled in the art, that the invention is not limited thereto and that the first surface 75 of the first component 60 may be adapted for receiving an incident light beam under an angle different from substantially orthogonal, whereby refraction occurs at the first surface 75 of the first component 60. The orientation of the second surface 80 of the first component 60 under the internal Brewster angle then should be referred to the direction of the light beam transmitted in the first component 60 after refraction at the first surface 75 of the first component 60.

The material used for producing the first component and the second component typically is an optical material. Common materials that may be used, the invention not being limited thereto, are optical glass, ZnSe, Ge, etc. For common materials the refractive index is always larger than 1, which leads to external Brewster angles larger than 45°. For a typical optical glass material with $n_m$=1.5, $\theta_{B,e}$ = 56.3°, for ZnSe optics in the infrared region with $n_m$ = 2.4, $\theta_{B,e}$ = 67.4°, for Germanium optics, with $n_m$ = 4, $\theta_{B,e}$ is equal to 76°. Depending on the physical characteristics of the material, the surfaces of the components of the device may be obtained by diamond turning, by moulding the form in a mould, or by imprinting the circular profiles directly in soft substrates.

It is an advantage of the present embodiment, that, for large beam sizes, the amount of material needed for manufacturing the polarisation device may be substantially smaller than the amount of material needed in prior art radial polarisation devices as described in Fig. 2. It thereby is to be noticed that for both devices, typically a complete cylinder of material is needed, having a volume sufficiently large such that the device can be made as a whole out of it. Due to the typically large external Brewster angles, the cone structure of the prior art device shown in Fig. 2 is quite sharp and hence this leads to large cone heights 65. The ratio between the cone radius 55 and the cone height 65 is equal to the refractive index $n_m$ of the cone material. The needed volume of material for the construction of the prior art optical component as shown in Fig. 2 with a radius R approximately is given by $\pi n_m R^3$. In the device according to the present embodiment of the invention, the ratio between the device radius 56 and the height 66 of the first component 60 is equal to the inverse of the refractive index $n_m$ of the first component material. The volume needed for the construction is approximately given by the formula: $\pi R^3/n_m$. In order to keep the transmitted light propagation in the same direction as before refraction at the second surface 80, it is necessary to use a second, complementary component 70, resulting in a doubling of the needed material. Preferentially the first component 60 and the second component 70 are made from the same material in order to maximise the transmission through the complete element 99.

Comparing the prior art polarisation selection device to the double component polarisation device of the first embodiment of the present invention teaches that the gain in amount of material is of the order of $n_m^2/2$. Table 1 shows that for higher index optics the advantage can be substantial for going from an external design towards an internal design, up to 8 for Germanium optics.

Table 1

| $n_m$ | $\theta_{B,e}$ | $R_\perp$ (%) | $\theta_{B,I}$ (°) | $V_{ext}/V_{int}$ | $V_{int}/V_{f\,old}$ (D=25mm;T=2.5mm) | $V_{ext}/V_{fold}$ (D=25mm;T=2.5mm) |
|---|---|---|---|---|---|---|
| 1.55 | 56.3 | 16 | 33.7 | 1.20 | 3.23 | 3.9 |
| 2.40 | 67.4 | 50 | 22.6 | 2.88 | 2.08 | 6.0 |
| 4.0 | 76.0 | 78 | 14.0 | 8.0 | 1.25 | 10.0 |

In use, the device displaces the light beam with respect to the input beam over a distance s in a direction parallel to the first surface 75 of the first component 60. This is due to refraction as the beam passes through components 60 and 70. If it is necessary to compensate this beam displacement s, it is preferable to use a second device 99, which has a similar structure, but with the two components 60 and 70 in the reverse order.

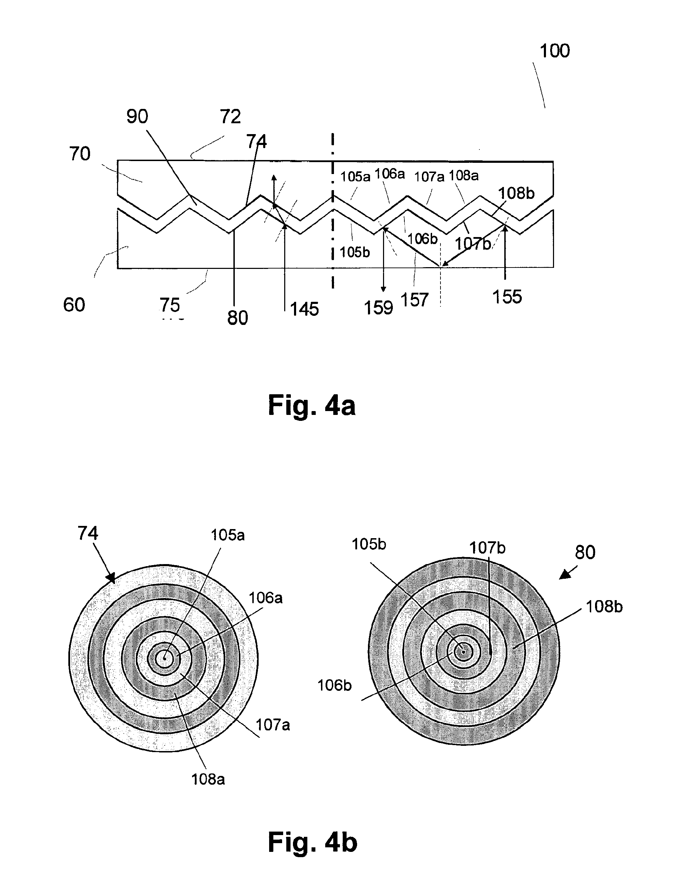

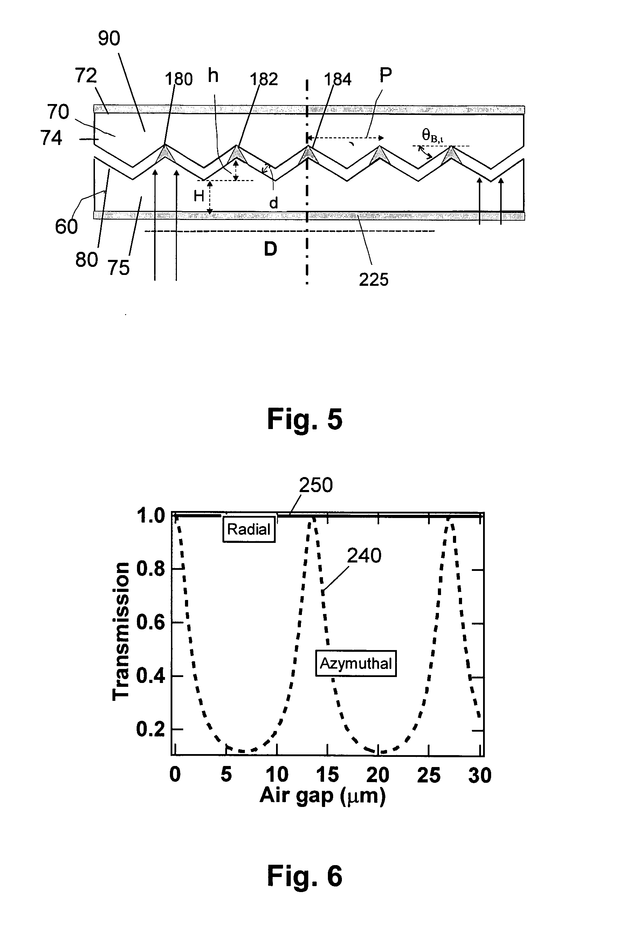

In a second embodiment, the present invention relates to a polarisation selecting device for selecting a radial polarisation state and/or azimuthal polarisation state according to the device of the first embodiment, wherein the device 100 comprises a second surface 80 of the first component 60 which is facetted and a second component 70 having a corresponding complementary second surface 74. An example of such a polarisation selecting device 100 is shown in Fig. 4a in cross-sectional view and in Fig. 4b, showing a top view of the second surfaces 80, 74 of the first component 60 and the second component 70 and in a more detailed cross-sectional view in Fig.5. The second surface 80 of the first component 60 comprises a plurality of facets 105b, 106b, 107b, 108b, ... and the complementary second surface 74 of the second component 70 comprises a plurality of facets 105a, 106a, 107a, 108a, .... These facets, 105a, 105b, 106a, 106b, 107a, 107b, 108a, 108b, include a first polarisation selective angle, e.g. substantially the internal Brewster angle $\theta_{B,i}$, or substantially minus the internal Brewster angle $-\theta_{B,i}$, which also may be referred to as a second polarisation selective angle, with the direction of incidence of the light beam on the second surface 80 of the first component 60. With "substantially the internal Brewster angle $\theta_{B,i}$" or "substantially minus the internal Brewster angle $-\theta_{B,i}$" is meant including an angle equal to the internal Brewster angle or an angle $\theta_{B,i} - \alpha_1$ or $\theta_{B,i} + \alpha_2$, or an angle equal to minus the internal Brewster angle or an angle $-\theta_{B,i} + \alpha_1$ or an angle $-\theta_{B,i} - \alpha_2$. $\alpha_1$ and $\alpha_2$ may be e.g. smaller than 12°, preferably smaller than 8°. Preferably, in order to keep the transmission losses of the wanted polarisation due to angle mismatch at maximum 10%, $\alpha_1$ preferably is smaller than 6° for low refractive index materials, such as e.g. glass type materials, smaller than 3.5° for medium refractive index materials such as e.g. ZnSe, and smaller than 0.25° for high refractive index materials, such as e.g. Ge, and $\alpha_2$ preferably is smaller than 3° for low refractive index materials such as e.g. glass type materials, smaller than 1.0° for medium refractive index materials such as e.g. ZnSe and smaller than 0.25° for high refractive index materials such as e.g. Ge.

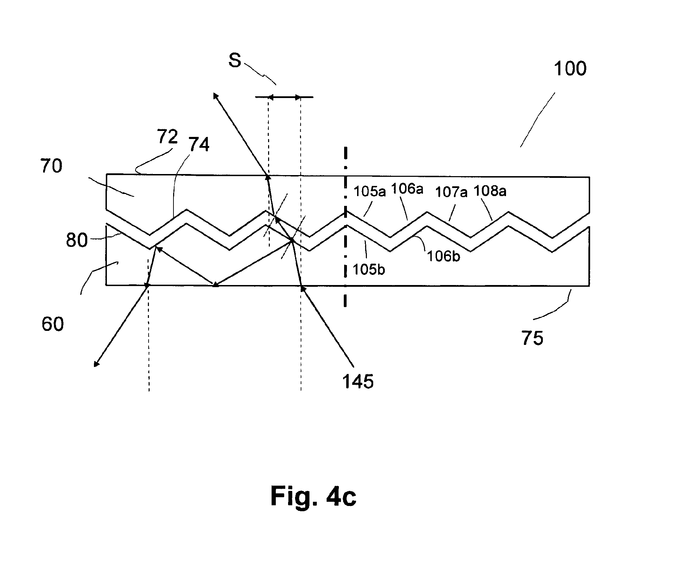

Although the devices according to the present embodiment may be optimised for receiving a substantially orthogonally incident light beam, an incident light beam also may be received non-orthogonally, as is illustrated by way of example in Fig. 4c.

The different facets of the surfaces are at least partly concentric, i.e. the surfaces are at least partly cylindrical symmetrical. Preferably, the different facets of the surfaces are fully concentric, i.e. fully cylindrical symmetrical. The different facets of the second surfaces may be alternatingly oriented along a first polarisation selective angle, which may be an angle of substantially the internal Brewster angle $\theta_{B,i}$ and along a second polarisation selective angle, which may for example be an angle of substantially minus the internal Brewster angle $-\theta_{B,i}$, i.e. where adjacent facets are oppositely oriented, resulting in second surfaces having a symmetric tooth-shaped cross-section or an asymmetric tooth-shaped cross section. The second surfaces thus may have a type of folded surface. Fig. 5 shows a detailed view of a symmetric tooth-shaped cross-section of the second surfaces 80, 74 of the first component 60 and the second component 70.

The height of the facets of the second surfaces 80, 74 can be a few orders of magnitude smaller than the height of the second surfaces in the first embodiment, resulting in a further reduction of the needed material for manufacturing the device. The latter is illustrated in table 1, showing the ratio of material volume $V_{int}$ needed for a conical device as shown in Fig. 3 to the material volume $V_{fold}$ needed for a device as shown in Fig. 5 according to the second embodiment. Comparison is also made with the material volume $V_{ext}$ needed for a prior art device, as shown in Fig. 2. As the second surfaces of the components look as they are folded, the device of the second embodiment may be referred to as "folded version". The volume of the material needed for manufacturing is in the present embodiment rather determined by the required mechanical strength of the optical component, which is related to the thickness H in Fig. 5. The required volume thus is mainly defined as $\pi R^2 H$. The values for the folded version of the device shown in table 1 correspond with a 2.5 mm thick 2.54 cm (1") diameter device. It can be seen that a further reduction of the required construction material is indeed obtained.

In use, depending on the polarisation state of the light of the light beam, the light path in the device as shown in Fig. 4a, Fig. 4b and Fig. 5 will be different. An incident light ray 145 of a first type, which is supposed to have only an electric field component parallel to the plane of incidence, is transmitted through the structure without any loss at the folded interfaces 105b, 105a, etc. The latter is representative for the radially polarised component of a light beam. An incident light ray 155 of a second type which has, on the other hand, only an electric field component orthogonal to the plane of incidence, and which represents the azimuthally polarised component of a light beam, is partially reflected back. After a total internal reflection on the flat surface 75, this light ray 157 will hit again one of the facets of the second surface 80. As a result, the reflected ray 159 can be totally evacuated from the optical element 100. The latter is advantageous as it prohibits residual absorption which would lead to a substantial heating of the device, especially in high optical power applications. This evacuation is possible when a light ray is reflected at oppositely oriented facets, as shown by way of example in Fig. 4a. A person skilled in the art can easily calculate the geometrical relationship between the thickness H, the period P, the depth h, and the internal Brewster angle $\theta_{B,i}$ such that the reflected part of the azimuthally polarised light is completely evacuated. This relationship is given by

$$(2.k+1)\frac{P}{2} = (2H + h).\tan(2.\theta_{B,i}) \qquad \text{[1a]}$$

$$P \tan\left(\theta_{B,i}\right) = 2h \qquad\qquad [1b]$$

wherein k is an integer number.

It is to be noted that this geometrical constraint cannot be fulfilled over the complete area of the second surface 80 of the first component 60. Light rays which are entering the device 100, close to the peaks of the symmetric teeth do not transmit into the second component but reflect at the second surface 74 of the second component 70, resulting in a reflected light component with radial polarisation state. So, the rays incident in the recombination zones 180, 182, 184, ... do not participate to the radial polarisation selection action. The teeth therefore may be topped, which would result in a trapezoidal shaped cross-section of the second surfaces 80, 74. In order to have a polarisation selection area that is as large as possible, it hence is recommended that this recombination zone is relatively small compared to the total area of the beam. This can be obtained by having designs with a substantial depth h. The period "P" of two complementary facets preferably is much larger than the wavelength $\lambda$ of the incident light in order to avoid diffraction effects. One can deduce that when the period of the folded surface is about 20 times larger than the wavelength, the diffracted pattern closely coincides with the refracted pattern, which would exist in the infinite period, flat device case. The larger the period, however, the deeper folds or teeth are required, which leads to thicker substrates and more required construction material and furthermore more removal of material during construction hence a slower fabrication process. When the period is large, the number of sharp cusps and crests are limited. At the crests, the device theoretically operates well, but when the crests are somewhat rounded due to imperfections in the fabrication process, the refraction angle criterion may not be completely satisfied. The latter may result in spurious reflections. Depending on the period "P" of the folded surface, this may be of minor consequence. At sharp cusps and crest, scattering losses are introduced. Hence, an optimal range of periods P exists, where the trade-off between scattering, diffraction and fabrication is optimised. By way of example, at a wavelength of 10 $\mu$m, one uses preferably a folded surface with a period ranging between 200 $\mu$m and 2 mm. As this recombination zone is also determined by the absolute distance "d" between the first and the second component 60, 70, i.e. the distance between these complementary parts, it is also recommended that this distance be small. Additionally, the facets 105a, 105b, 106a, 106b, 107a, 107b, 108a, 108b or a number thereof, can be coated with one or more layers for improving the polarisation contrast of the device.

The distance "d" influences the contrast between azimuthally and radially polarised light that is transmitted through the device and thus cannot be freely chosen. Curve 240 in Fig. 6 which shows the variation of the transmission of the electric field vectors in the plane of incidence for a radial Brewster design by way of example in a ZnSe optic at a wavelength of 10.6 $\mu$m, indicates that there exist interferometric extrema where minimum or maximum transmission occurs. In order to have a high polarisation contrast it is required to have a minimum transmission of the azimuthal polarisation state and a maximum of the radial polarisation state. Curve 250 teaches that the transmission of the radial polarisation state is not dependent on the distance "d" between both components of the radial polariser.

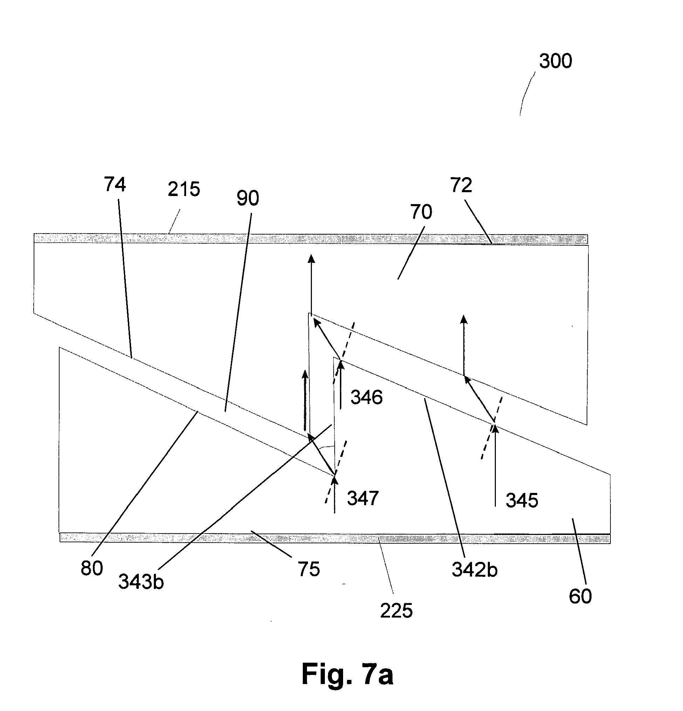

In a third embodiment, the invention relates to a device according to the second embodiment, wherein the facets are oriented such that a higher polarisation selection efficiency can be obtained by reducing the recombination regions 180, 182, 184 present in the second embodiment. As evacuation of reflected light is less optimised, this embodiment is preferred for low optical power level applications, where the issue of residual absorption of light is less important. Reduction of the recombination regions 180, 182, 184, ... is obtained by selecting facets alternatingly including a polarisation selective angle, which may e.g. be an angle of substantially the internal Brewster angle or minus the internal Brewster angle, with the incident light beam, i.e. facets 342b, and including an angle of substantially zero degrees with respect to the incident light beam, i.e. facets 343b. The latter results in a saw-tooth shaped cross-section. An example of a device 300 according to the third embodiment is shown in Fig. 7a. In this embodiment the transmission efficiency for the radially polarised component of all rays 345, even for the extreme rays 346 and 347, is equal to 100 %. The evacuation of the reflected polarised component is not ideal in this embodiment, but for lower optical power levels this is less important.

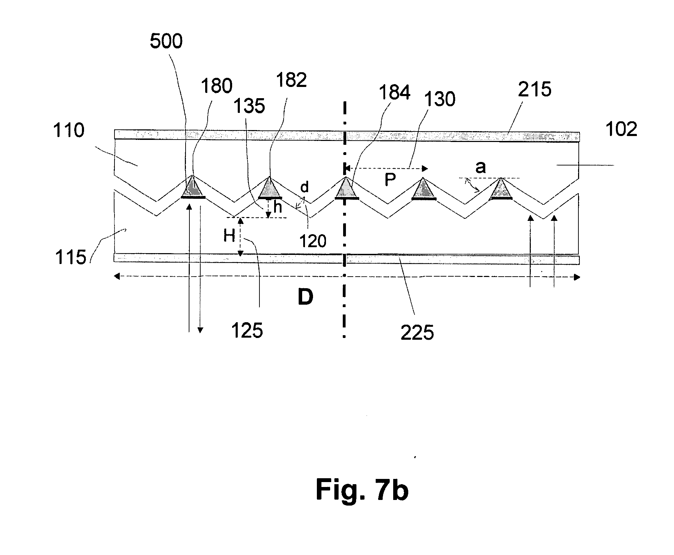

In a fourth embodiment, the invention relates to a device according to the second embodiment, whereby means are provided for obtaining minimum scattering at the cusps of the recombination zones 180, 182, 184, ... In the recombination zones 180, 182, 184 polarisation selection is not optimal. The means for obtaining minimum scattering at the cusps of the recombination zones 180, 182, 184, ... may be an absorption or reflective means, such as e.g. an absorption layer or reflective layer, provided at the cusps of the recombination zone. In addition, the shape of the cusps surfaces of the recombination zones 180, 182, 184, ... may be partly flattened. The latter is illustrated by way of example in more detail in Fig. 7b. In the present embodiment the transmission efficiency for the radially polarised component of all light rays may be slightly reduced but the evacuation of the reflected polarised component is improved, leading to a decrease of unexpected scattering losses.

In a fifth embodiment, the invention relates to any of the devices of the other embodiments of the present invention, wherein any of the flat surfaces 75, 72 of the first component 60 and/or of the second component 70 are covered by an anti-reflection coating 215, 225, as shown for example in Fig. 5 and Fig. 7a and Fig. 7b, in order to limit optical Fresnel losses at these surfaces. The type of anti-reflection coating used typically depends on the wavelength of the light used and on the power of the light beam that is used. For the case of a typical high power $CO_2$ laser beam operating at mid-IR wavelengths, the anti-reflection coating may preferably be made from $ThF_4$, $BaF_2$, $MgF_2$, $SrF_2$, or IRX, although the invention is not limited thereto.

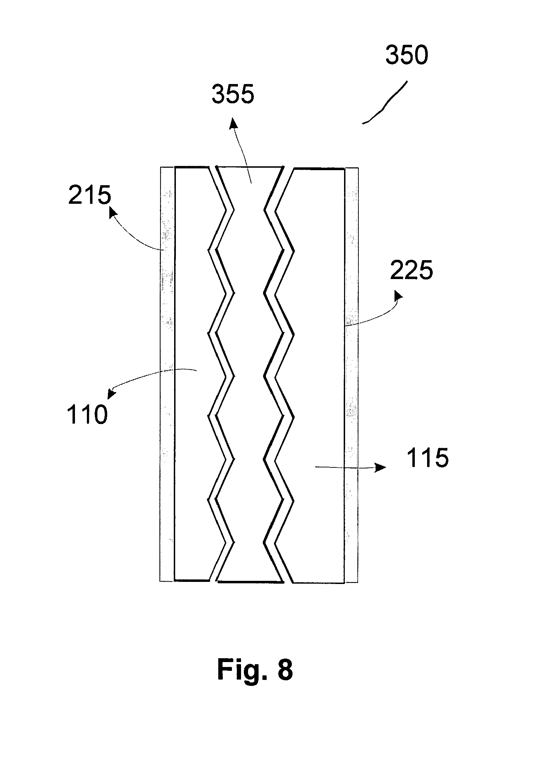

In a sixth embodiment, the obtained polarisation contrast between radial polarised light and azimuthal polarised light can be further increased by having one or more intermediate components in between the first component and the second component of the device, each of the intermediate components comprising a first surface and a second surface, whereby these surfaces have a shape which is substantially complementary to the shape of the adjacent surfaces of the adjacent components. These surfaces are also at least partly concentric, i.e. at least partly cylindrical symmetrical. The intermediate components are spaced from adjacent components, which may be other intermediate components or the first component or the second component, by a gap, thus introducing a refractive component/gap interface. A device 350 with an intermediate component 355 sandwiched between a first component 110 and a second component 115 is shown in Fig. 8. Additional features such as antireflective coatings 215, 225 also may be present. Intermediate components 355 can be used for each of the described polarisation selection devices described, and even for a mixture thereof. In other words, the polarisation contrast between the radial and azimuthal polarisation state can be increased with multi-element designs.

In a seventh embodiment, the present invention relates to an optical system comprising a polarisation selection device according to any of the above-described embodiments. The polarisation selection device may comprise the same characteristics and advantages as those described in any of the previous embodiments. The optical system may be any of a laser based system such as a laser based material processing device, e.g. a laser ablation system, a laser cutting system, a laser drilling system, etc., a lithographic system, a microscopic system, etc. The polarisation selection device may be positioned anywhere along the optical path of the optical system. The optical system may be or may comprise a laser cavity comprising the polarisation selection device internally, i.e. between the mirrors or externally.

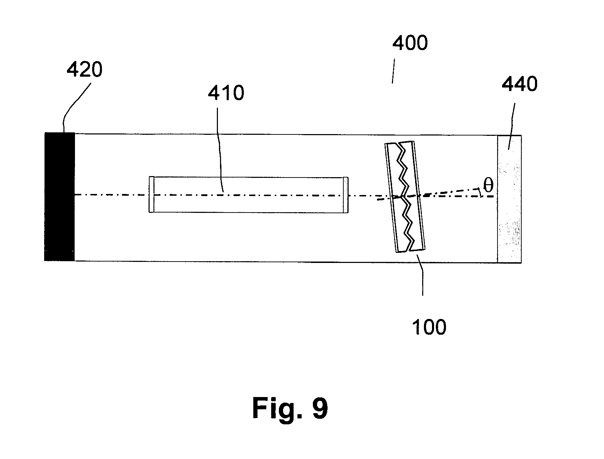

A laser cavity comprising a polarisation selection device is shown in Fig. 9. A basic configuration of a laser cavity 400 typically comprises a lasing medium 410, a backside mirror 420 and an output coupler 440 which organise the lasing action. In order to produce radially polarised outgoing laser light, a polarisation selection device 100 according to any of the previous embodiments is introduced in the cavity. The polarisation selection device 100 may be introduced under a slight tilt angle $\alpha$. The tilt angle $\alpha$ should be at least larger than the divergence of a laser beam, preferably at least a few times, e.g. 3 times or 5 times or 10 times, the divergence of a laser beam. The divergence of a laser beam typically may be about 1 miliradian or 3 arc minutes, i.e. 0,05°. The upper limit for the tilt angle $\alpha$ may e.g. be determined by $Arcsin(n_m sin\alpha_2)$ with $\alpha_2$ being smaller than 3° for low refractive index materials such as e.g. glass materials, smaller than 1.0 degrees for medium refractive index materials such as e.g. ZnSe and smaller than 0.25° for high refractive index materials, such as e.g. Ge. By slightly tilting the device 100 the reflected rays propagate in a non-orthogonal direction with respect to the mirrors 420, 440 and thus are not in condition for forming standing waves, i.e. are not in condition for lasing action. Hence only the radially polarised components can yield standing wave patterns inside the cavity and result in lasing action.

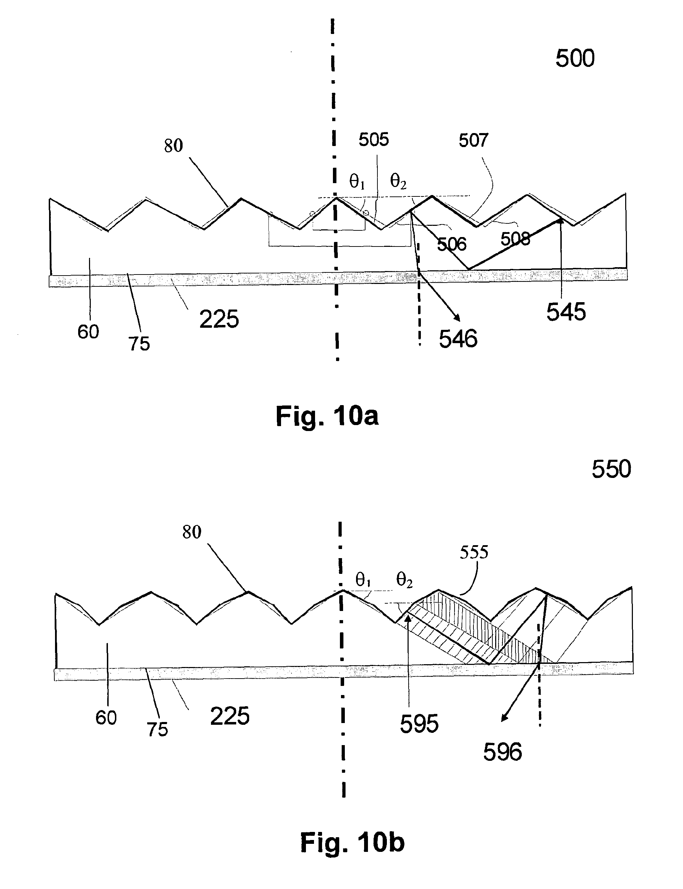

In an eighth embodiment, the present invention relates to a device for selecting a polarisation state, e.g. a radial polarisation state, of a light beam, according to any of embodiments 1 to 5, wherein slight asymmetries or deviations are introduced in the orientation of at least part of the second surface 80 of the first component 60 and the corresponding complementary second surface 74 of the second component 70 to avoid lasing action of the reflected light, when the polarisation selection device is introduced perpendicular to the lasing light wave. Examples of such polarisation selection devices are shown in Fig. 10a and Fig. 10b. Fig. 10a and Fig. 10b show only one part of the two complementary parts of a radial polarisation selection design. Fig. 10a shows a first example of a device 500 comprising a plurality of first facets 505, 507,... and a plurality of second facets 506, 508, ..., the first and second facets alternating each other and being adjacent, wherein the first facets 505, 507 are characterised by an angle $\theta_1$ slightly larger than the internal Brewster angle $\theta_{B,i}$ and the second facets 506, 508 are characterised by an angle $\theta_2$ slightly smaller than the internal Brewster angle $\theta_{B,i}$, with reference to the direction of incidence of light. In other words, the first facets include an angle $\theta_{B,i} - \alpha_1$ with the direction of incidence of light, with $\alpha_1$ being smaller than 6° for low refractive index materials (e.g. glass type materials), smaller than 3.5 degrees for medium refractive index materials (e.g. ZnSe) and smaller than 0.25° for high refractive index materials (e.g. Ge) and $\alpha_1$ being larger than the divergence of the light beam, preferably 3 times or 5 times or 10 times the divergence of the light beam, and the second facets include an angle $\theta_{B,i} + \alpha_2$ with the direction of incidence of light, with $\alpha_2$ being smaller than 3° for low refractive index materials, smaller than 1.0 degrees for medium refractive index materials and smaller than 0.25° for high refractive index materials but $\alpha_2$ being larger than the divergence of the light beam, preferably 3 times or 5 times or 10 times the divergence of the light beam.

The device is then so organised that all incident light rays 545 which reflect back hit inside the optical components two different facets. In this way the reflected light rays 546 leave the optical device under a non-orthogonal angle. The transmitted waves in an asymmetric complementary coupled design remain perpendicular to the outcoupling surface of the second component due to the refraction at the complementary second surface 74 of the second component 70 of the polarisation selection device 500.

In alternative example device 550, non-orthogonal reflected rays are obtained by dividing each facet 555 in two regions, whereby in a first region the fabrication angle is slightly smaller than the internal Brewster angle $\theta_{B,i}$, e.g. an angle $\theta_{B,i} - \alpha$, with $\alpha$ being between 0.1 ° and 6°, the smallest values for high refractive index materials and the larger values for low refractive index materials and in the second region slightly larger $\theta_{B,i}$, e.g. an angle $\theta_{B,i} + \alpha$, with $\alpha$ being between 0.1 ° and 3°, the smallest values for high refractive index materials and the larger values for low refractive index materials, or vice versa.

The design is then so organised that all incident rays 595 which reflect back hit inside the optical components the two different regions of a facet, i.e. once they reflect under a first angle, and once under a second angle. The resulting reflected ray 596 leaves the device under a non-orthogonal direction.

This embodiment has the advantage that for positioning the polarisation selection device, the outer surfaces of the device can be introduced perpendicular to the lasing light wave.

In a ninth embodiment, the present invention relates to a polarisation selection device and a method for selecting a polarisation state, e.g. a radial polarisation state, of a light beam, according to any of embodiments 1 to 5, wherein the second surface 80 of the first component 60 and the second surface 74 of the second component 70 are such that a sufficient part of the light having a non-wanted polarisation state undergoes a beam expansion, i.e. is diverged. For facetted second surfaces for example, the latter can be obtained by selecting the integer number k, in the geometrical relationship describing the geometry of these surfaces, i.e. in equations [1 a] and [1b], sufficiently large. Due to the beam expansion, i.e. divergence, when used in a laser system, no lasing action of the reflected light is obtained or in other words, lasing action of the reflected light having a non-wanted polarisation state is avoided, even when the polarisation selection device is introduced perpendicularly to the lasing light wave. The minimum value of the integer number k in the geometrical relationship describing the geometry of the surfaces of the components thus is chosen such that lasing action for the unwanted polarisation cannot take place. A possible criterion, the invention not being limited thereto, may e.g. be that the losses due to beam expansion, i.e. divergence, of the unwanted polarisation state are e.g. more than 25%. Equation [2] gives a first estimation of a relationship which is to be fulfilled by the integer value k in order for such a realisation, i.e. whereby the divergence leads to a 25% loss of the unwanted polarisation state, to occur. Equation [2] is given by

$$\left(2.k+1\right)\frac{P}{2} \geq \frac{\phi}{8} \qquad\qquad\qquad [2]$$

$\phi$ thereby is the beam diameter.

Such a polarisation selection device also has the advantage that it can be introduced orthogonally in a laser system while still allowing to prevent unwanted light from lasing action.

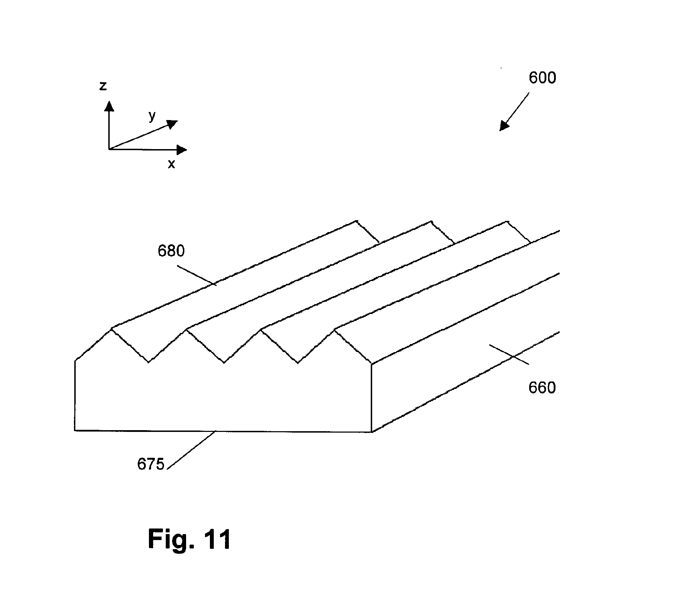

In a tenth embodiment, the invention relates to any of the device embodiments as described above, wherein the shape of the second surfaces of the first and the second components are not concentric or conical, but wherein the facets of the second surfaces of the two components all extend in a same direction. In this way linear polarisation components can be selected. An exemplary illustration is provided in Fig. 11, showing one of two components 660 of such a polarisation selection device 600, the second component being complementary as described in any of the above device embodiments. In the device component 660 shown, the facets of the second surface 680 extend all in the y-direction, as indicated in the figure. The second surface 680 may be shaped such that any cross-section perpendicular to said same direction is substantially tooth-shaped, whereby substantially tooth-shaped may be symmetrically tooth-shaped, asymmetrically tooth-shaped or sawtooth-shaped. The different facets of the second surfaces thereby still are oriented substantially at a first polarisation selective angle, which may be substantially at the internal Brewster angle $\theta_{B,i}$ and/or substantially at minus the internal Brewster angle - $\theta_{B,i}$ and a second polarisation selective angle, which may be substantially the opposite thereof, with respect to a direction of a beam incident on the second surface. In this case the polarization selection properties of the device substantially completely transmit a first linear polarisation direction, which e.g. is the TM-polarised state, but only partly transmit the linear polarisation direction perpendicular thereto, e.g. according to the TE polarised state. Similar features as for the above-described device embodiments of the present invention may be provided to the polarisation selection device of the present embodiment, resulting in similar advantages. The present embodiment is especially advantageous when a folded version with a plurality of facets is provided. It has the advantage of being a material saving solution with respect to the classical Brewster plate. It is well known in the art that in the infrared region where high refractive index materials are used such as ZnSe (n=2.4) or Ge (n=4.0) for classical Brewster plates the length of the device needs to be at least 2.5 to 4.5 times larger than the required width of the device due to the large Brewster angles, i.e. typically between 65° and 80°. Larger devices of course need to be thicker to maintain mechanical strength and stability. The larger the beam size, the thicker the optical component is. This leads to larger lateral displacements of the optical beam. When combining a set of Brewster polarisers in order to increase the polarisation ratio, and when they are combined in such way that they compensate the displacement, the mechanical housing gets extended, i.e. being at least twice as long as the length of the Brewster plates. In a folded linear Brewster polarisation selection device, part thereof being shown in Fig. 11, the total thickness of the structure is only determined by the required mechanical strength of the optical component, i.e. order of millimeters. For 10 mm laser beams it can be calculated that the housing of the classical beam propagation compensated double Brewster plate, being at least 5 to 9 times longer than the laser beam, is 10 to 20 times larger than in the case of a linear folded Brewster polarizer according to the present embodiment.

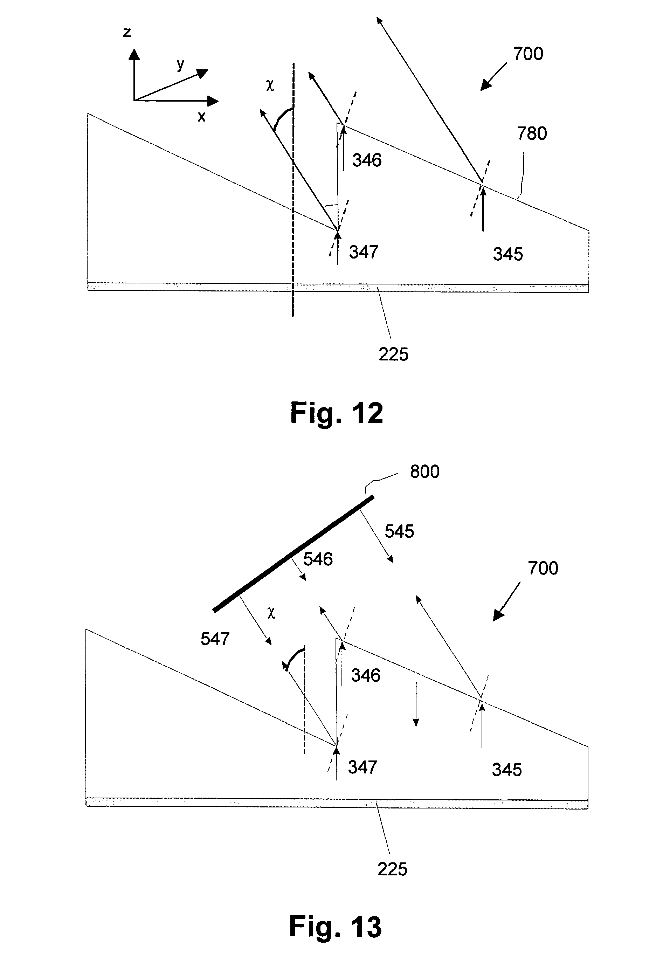

In a second aspect, the invention also relates to a polarisation selection device according to any of the devices as described in the previous embodiments, wherein only a single component, described in the previous device embodiments as the first component, is present. In other words, the devices according to the present embodiment correspond with any of the devices as described above, wherein the second component is absent. In all of these embodiments, light having a predetermined polarisation direction, such as e.g. linearly polarised, radially polarised or azimuthally polarised light, can be selected, but using only the single component leads to an outgoing polarized illumination beam propagating in a propagation direction not coincident, i.e. parallel, with the incident one. The single component typically comprises a first surface that is adapted for receiving an incident light beam and for guiding the received light beam 345, 346, 347 in a first direction towards a second surface 780 of the single component. The first surface preferably may be substantially flat, e.g. as the bottom surface shown in Fig. 12. At least part of the second surface 780 includes a polarisation selective angle with the first direction of the light beam incident on the second surface. The polarisation selective angle may be, but is not limited to, substantially the internal Brewster angle $\theta_{B,i}$ or substantially minus the internal Brewster angle $-\theta_{B,i}$. It is to be noted that the term "internal Brewster angle" refers to the conventional Brewster angle for light that propagates from a high refractive index material to a low refractive index material. With "at least part" is meant at least 50% of the second surface, preferably at least 66% of the second surface 80, even more preferably at least 75% of the second surface, or there may be meant substantially the full second surface being under substantially a polarisation selective angle and/or substantially minus that polarisation selective angle. With "substantially the internal Brewster angle $\theta_{B,i}$ or substantially minus the internal Brewster angle $-\theta_{B,i}$", is meant including an angle equal to the internal Brewster angle or an angle $\theta_{B,i} + \alpha$ with the direction of the light beam, with $\alpha$ being in the interval [-6°;+3.0°] for low refractive index materials (e.g. glass type materials), in the interval [-3.5°;+1.0°] for medium refractive index materials such as ZnSe and in the interval [-0.25°;+0.25°] for high refractive index materials such as Ge, or an angle equal to minus the internal Brewster angle or an angle $-\theta_{B,i} - \alpha$, with $\alpha$ being in the interval [-6°;+3.0°] for low refractive index materials (e.g. glass type materials), in the interval [-3.5°;+1.0°] for medium refractive index materials such as ZnSe and in the interval [-0.25°;+0.25°] for high refractive index materials such as Ge.

According to different embodiments of the second aspect the second surface may be at least partly substantially elongate, similar to the components described in the 10th embodiment, may be substantially elongate, may be at least partly concentric or may be substantially concentric. The second surface thus may have a conical shape. The second surface 780 may comprise at least one facet making a polarisation selective angle with the first direction of the light beam incident on the second surface. The polarisation selective angle may be, but is not limited to, substantially the internal Brewster angle $\theta_{B,i}$ or substantially minus the internal Brewster angle $-\theta_{B,i}$. The second surface also may comprise a plurality of facets making a polarisation selective angle with the first direction of the light beam incident on the second surface. The second surface 780 may also comprise a first plurality of facets including a polarisation selective angle with the propagation direction of the light beam and a second plurality of facets including substantially the opposite polarisation selective angle with the propagation direction of the light beam. The second surface 780 thus may e.g. have a sawtooth, symmetrical sawtooth or asymmetrical sawtooth shape.

In case the polarisation selection angle used is the Brewster angle, the new propagation angle $\chi$ may be equal to the difference between the external and the internal Brewster angles, i.e. $\chi = \theta_{B,e} - \theta_{B,i}$. An exemplary illustration of a device according to the second aspect is provided in Fig. 12, showing the single component device 700. In the present example shown in Fig. 12, provided by way of illustration, the facets of the second surface 780 extend all in the y-direction indicated in Fig. 12. In the present example, wherein a first plurality of facets is oriented under a first polarisation selective angle, the polarization selection properties of the device substantially completely transmit a first linear polarisation direction, which e.g. is the TM-polarised state, but only partly transmit the linear polarisation direction perpendicular thereto, e.g. according to the TE polarised state. Similar features as for the above-described device embodiments of the present invention may be provided to the polarisation selection device of the present embodiment, resulting in similar advantages. It will be obvious for a person skilled in the art that other features, such as e.g. - but not limited to - an anti-reflective coating 225, as described for the other embodiments of the present invention, may be provided.

Devices according to the second aspect of the invention have the advantage of being a material saving solution with respect to the classical Brewster plate and have the advantage of containing substantially less material than the devices according to the previous 2-component embodiments. Nevertheless, the single element polarizers according to the second aspect of the invention have a smaller polarization filtering function than the devices of the previous embodiments, and the property that the outgoing beam leaves the device under a different propagation angle.

In a further embodiment according to the second aspect of the invention, devices and methods according to the embodiments of the second aspect are provided, whereby the original propagation direction can be restored for the illumination beam that passed the polarisation selection device. The latter can be done with any suitable optical device, known by persons skilled in the art, e.g. mirrors, prisms,.... It is also possible to use this embodiment in reflective operation instead of in transmission operation by using the polarization sensitive device 700 in combination with a mirror 800 as shown in Fig. 13. The waves 345, 346, 347 incident on the second surface are leaving the polarization selective device under an angle χ and reflect on mirror 800 to produce the reflected waves 545, 546, 547, which will be incident again on the device 700 under a further polarisation selective angle. For a first polarisation selective angle being the internal Brewster angle $\theta_{B,i}$, the redirected light beam may have an angle of incidence on said component being the external Brewster angle $\theta_{B,e}$. It may be advantageous to use a mirror as the latter allows to avoid the need for a second component, while nevertheless a second polarisation selection step is performed.

It is an advantage of embodiments of the present invention that the devices for producing radially polarised light beams have broad-band characteristics. The spectral bandwidth of a single element is determined by the spectral variation of the refractive index of the optical material. For example for ZnSe, the Brewster angle variation between 1 and 15 μm wavelength is only 1 degree. Hence a single radially folded polariser designed for a wavelength of 7.5 μm can be used in the wavelength interval 1 to 15 μm with only a slight degradation in radial polarisation performance. It is furthermore an advantage that the devices for producing radially polarised light beams can be used in many spectral domains of the electromagnetic spectrum, e.g. for X-ray optics, UV-optics, visible optics, all kind of infrared, even for millimetre wave and microwave optics.

It is an advantage of the embodiments of the present invention that the combined complementary concentric ring shaped surfaces implement the radial polarising function and the required high transmission coefficient.

It is also an advantage of the present invention that the angle accuracy for the devices is not too critical. It means that the angular accuracy of the declined surface can be in the range $-\alpha_1$ to $+\alpha_2$ degrees, which has an important impact on the fabrication tolerances.

It is to be understood that although preferred embodiments, specific constructions and configurations, as well as materials, have been discussed herein for devices according to the present invention, various changes or modifications in form and detail may be made without departing from the scope and spirit of this invention. For example, whereas in the above embodiments devices are described, the invention also relates to the corresponding methods. The invention e.g. relates to a method for creating a substantially polarised light beam, the method comprising providing a light beam perpendicularly to a first medium, refracting the light beam at a surface of said first optical component including an angle being substantially an internal Brewster angle for said first optical component with said light beam, , resulting in a first sub-beam coupled out of the first medium, providing the first sub-beam under an angle being substantially an external Brewster angle of said second medium, resulting in a second sub-beam coupled in into said second medium, and coupling out said second sub-beam from said second medium. The method also may comprise guiding the first sub-beam through a gap, e.g. an airgap.

## Claims

1. A device (99, 100, 300, 350, 500, 550) for selecting a polarisation state of light of a light beam, the device (99, 100, 300, 350, 500, 550) comprising at least a first component (60) and a second component (70),

    said first component (60) comprising a first surface (75) and a second surface (80), said first surface (75) being adapted for receiving an incident light beam and guiding said light beam in a first direction to a second surface (80), at least part of said second surface (80) making a first polarisation selective angle with respect to said first direction, and

    said second component (70) comprising a first surface (72) being adapted for coupling out from said second component an incident light beam and a second surface (74) having a shape being substantially a complementary shape of said second surface (80) of said first component (60),

    said first component (60) and said second component (70) being adapted to be offset from each other such that light leaving said second surface (80) of said first component (60) is at least partly coupled into said second component (70) via said second surface (74) of said second component (70).

2. A device (99, 100, 300, 350, 500, 550) according to claim 1, wherein the first polarisation selective angle is substantially the internal Brewster angle $\theta_{B,i}$ and/or substantially minus the internal Brewster angle - $\theta_{B,i}$, $\theta_{B,i}$ being the complement of the external Brewster angle $\theta_{B,e}$, said external Brewster angle being determined by

$$\tan(\theta_{B,e}) = n_m$$

**3.** A device (99, 100, 300, 350, 500, 550) according to any of the previous claims, wherein said at least part of said second surface (80) of said first component comprises at least one first facet including said first polarisation selective angle with said first direction.

**4.** A device (99, 100, 300, 350, 500, 550) according to claim 3, wherein said at least part of said second surface (80) of said first component comprises at least one second facet including a second polarisation selective angle with said first direction, said second polarisation selective angle being substantially different from said first polarisation selective angle.

**5.** A device (100, 350, 500, 550) according to any of claims 1 to 4, wherein said at least part of said second surface (80) of said first component (60) comprises at least a plurality of first facets (105b, 107b, ...) including said first polarisation selective angle with a direction of an incident light beam.

**6.** A device (100, 350, 500, 550) according to any of claims 4 to 5, wherein said at least part of said second surface (80) of said first component (60) comprises at least a plurality of second facets (106b, 108b) including said second polarisation selective angle with respect to a direction of an incident light beam.

**7.** A device (300) according to any of claims 3 to 5, wherein said at least part of said second surface (80) of said first component comprises at least a plurality of second facets (343b) being substantially parallel with said direction of said incident light beam.

**8.** A device (100, 350, 500, 550) according to any of claims 6 or 7, wherein said first component (60) and said second component (70) are offset such that light coupled out through said first facets (105b, 107b) of said first component (60) substantially is coupled into said first facets (105a, 107a) of said second component (70) and light coupled out through said second facets (106b, 108b) of said first component (60) substantially is coupled into said second facets (106a, 108a) of said second component (70).

**9.** A device (99, 100, 300, 350, 500, 550) according to any of the previous claims, wherein the shape of said second surface (80) of said first component (60) and said second surface (74) of said second component (70) are concentric.

**10.** A device (99, 100, 300, 350, 500, 550) according to any of claims 3 to 8, wherein facets at said second surface all extend in a same direction.

**11.** A device (99, 100, 300, 350, 500, 550) according to any of the previous claims, wherein said device (99, 100, 300, 350, 500, 550) furthermore comprises a means for mechanically offsetting said components (60, 70), adapted for creating a gap (90) between said components (60, 70).

**12.** A device (350) according to any of the previous claims, said device (350) furthermore comprising at least one intermediate component (355), said intermediate component (355) having a first surface and a second surface, opposite said first surface, at least part of each of said first surface and said second surface including a polarisation selective angle with a direction of an incident light beam, said intermediate component being adapted for being positioned with said first surface and said second surface between said first component (60) and said second component (70).

**13.** A device (99, 100, 300, 350, 500, 550) according to any of the previous claims, the device comprising recombination zones between said second surfaces (80, 74), wherein at least one of the second surfaces (80, 74) comprises a reflecting or absorbing means located in a substantial part of the recombination zones (180, 182, 184).

**14.** An optical system comprising a light source adapted for generating a light beam and a device (99, 100, 300, 350, 500, 550) adapted for selecting a radial or azimuthal polarisation state of said light beam according to any of the previous claims.

**15.** A laser comprising a laser cavity (400) adapted for supporting lasing action and a device (99, 100, 300, 350, 500, 550) adapted for selecting a polarisation state of said light beam according to any of claims 1 to 14 wherein said device (99, 100, 300, 350) is positioned such that light reflected at said first surface (75) of said first component (60) is substantially not coinciding with the optical path of the laser cavity (400).

16. A laser comprising a laser cavity (400) adapted for supporting lasing action and a device (500, 550) adapted for selecting a polarisation state of said light beam according to claims 1 to 14, wherein said device (500, 550) is positioned such that said first surface (75) of said first component (60) is perpendicular to the optical path of the laser cavity and is adapted such that light reflected at said second surface (80) of said first component (60) is coupled out of said first component substantially not coincident with the optical path of the laser cavity (400).

17. A method for creating a substantially radially polarised light beam, the method comprising

- providing a light beam perpendicularly to a first optical component (60),
- refracting said light beam at a surface of said first optical component making an angle being substantially an internal Brewster angle for said first optical component (60) with said light beam, resulting in a first sub-beam coupled out of said first optical component (60),
- providing said first sub-beam at an angle being substantially an external Brewster angle of a second optical component (70), resulting in a second sub-beam coupled in into said second optical component (70),
- coupling out said second sub-beam from said second optical component (70).

18. A method according to claim 17, wherein after refracting said light beam and prior to providing said first sub-beam, the method comprises guiding said first sub-beam through a gap (90) between the first optical component (60) and the second optical component (70).

19. A method according to any of claims 17 or 18, said light beam having a symmetry axis, wherein providing a light beam to said first optical component (60) comprises providing said light beam such that the symmetry axis of the light beam passes through the centre of symmetry of the active area of said first and said second optical component (60,70).

20. A method according to any of claims 17 to 19, said method furthermore comprising, after said providing a light beam perpendicular to a first optical component (60),
reflecting at least partially the orthogonal unwanted polarisation state such that it at least part thereof is directed substantially orthogonally to the first surface (75) of said first optical component (60) and that at least part thereof is substantially coupled out.

21. A method according to any of claims 17 to 20, the method further comprising absorbing or reflecting that part of the light beam that is incident on the recombination parts (180, 182, 184) of the second surfaces (80, 74) of the first and second optical components (60, 70)

$\overline{E}$

10

**Fig. 1a – prior art**

25

$\vec{E}$

20

**Fig. 1b – prior art**

**Fig. 2 – prior art**

**Fig. 3**

100

90  72

74

70

105a 106a 107a 108a

108b

105b

106b

107b

60  75  80  145  159  157  155

**Fig. 4a**

74  105a

106a

105b  107b  80

108b

107a

106b

108a

**Fig. 4b**

**Fig. 4c**

**Fig. 5**

**Fig. 6**

300

74    215    90                        72
                          70

80
  343b            75            342b
                          225        60

# Fig. 7a

346
347
345

**Fig. 7b**

**Fig. 8**

**Fig. 9**

500

**Fig. 10a**

550

**Fig. 10b**

z

y

x

600

680

660

675

**Fig. 11**

**Fig. 12**

**Fig. 13**

European Patent
Office

**EUROPEAN SEARCH REPORT**

Application Number

EP 05 01 5451

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 755 027 A (SCHAEFER ET AL) 5 July 1988 (1988-07-05) | 1-12,14, 17-20 | G02B5/30 G02B27/28 |
| Y | * column 2, line 3 - line 11 * * column 2, line 39 - column 3, line 5 * * column 3, line 37 - column 4, line 6 * * column 6, line 3 - line 28 * ----- | 15,16 | |
| Y | US 5 359 622 A (SHIH ET AL) 25 October 1994 (1994-10-25) * column 1, line 61 - column 2, line 19 * * column 3, line 49 - column 5, line 14 * ----- | 15,16 | |
| X | DE 103 21 598 A1 (CARL ZEISS SMT AG) 2 December 2004 (2004-12-02) * paragraphs [0001], [0006], [0039], [0045]; figures 1,2,5 * ----- | 1-12,14, 17-20 | |
| A | US 3 912 921 A (HOWE ET AL) 14 October 1975 (1975-10-14) * abstract * * column 2, line 29 - line 56; figure 3 * ----- | 5-8 | |

TECHNICAL FIELDS
SEARCHED      (IPC)

G02B

The present search report has been drawn up for all claims

| Place of search | Date of completion of the search | Examiner |
|---|---|---|
| The Hague | 16 December 2005 | Cohen, A |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

................................................................................

& : member of the same patent family, corresponding
    document

EPO FORM 1503 03.82 (P04C01)

**ANNEX TO THE EUROPEAN SEARCH REPORT**
**ON EUROPEAN PATENT APPLICATION NO.**                    EP 05 01 5451

This annex lists the patent family members relating to the patent documents cited in the above-mentioned European search report.
The members are as contained in the European Patent Office EDP file on
The European Patent Office is in no way liable for these particulars which are merely given for the purpose of information.

16-12-2005

| Patent document cited in search report | | Publication date | Patent family member(s) | | Publication date |
|---|---|---|---|---|---|
| US 4755027 | A | 05-07-1988 | DE | 3523641 C1 | 18-12-1986 |
| | | | JP | 63014004 A | 21-01-1988 |
| US 5359622 | A | 25-10-1994 | NONE | | |
| DE 10321598 | A1 | 02-12-2004 | WO | 2004102273 A2 | 25-11-2004 |
| US 3912921 | A | 14-10-1975 | NONE | | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **WILSON et al.** *Optical Engineering,* 2003, vol. 42 (11), 3088-89
- **NEIL et al.** *Opt. Lett.,* 2002, vol. 27, 1929-1931
- **TIDWELL et al.** *Appl. Opt.,* 1990, vol. 29, 2234
- **K. S.YOUNGWORTH ; T.G.BROWN et al.** *Proc. SPIE,* 2000, vol. 3919
- **CHURIN et al.** *Opt. Comm.,* 1993, vol. 99, 13
- **NESTEROV et al.** *J. Phys. D. Appl. Phys.,* 1999, vol. 32, 2871-75
- **ORON et al.** *Appl. Phys. Lett.,* 2000, vol. 77 (21), 3322-3324
- **MOSHE et al.** based on the different focusing between radially and tangentially polarised light (bi-focusing) in thermally stressed isotropic laser rods, as described in. *Opt. Lett.,* 2003, vol. 28 (10), 807-809
- **MOSER et al.** *Laser Physics Letters,* 2004, vol. 1 (5), 234-236